# EUROPEAN PATENT SPECIFICATION

(11) **EP 1 772 797 B1**
(45) Date of publication and mention of the grant of the patent: **13.06.2007**
(21) Application number: 05109309.4
(22) Date of filing: 07.10.2005
(51) Int. Cl.: G06F 1/16, H01M 2/10, H04B 1/38, H04M 1/02, H05K 5/00

(54) **Expandable battery compartment for handheld electronic devices**
Erweiterbares Batteriefach für tragbare elektronische Geräte
Compartiment de piles extensible pour dispositifs électroniques portatifs

(43) Date of publication of application: 11.04.2007
(60) Divisional application: 07104434.1
(73) Proprietor: Research In Motion Limited, Waterloo, Ontario N2L 3W8 (CA)
(72) Inventor: Ladouceur, Norman M, Waterloo, Ontario N2T 1A2 (CA); Griffin, Jason T, Kitchener, Ontario N2P 2L3 (CA); Tyneski, Frank, 92075 Solana Beach California (US)
(74) Representative: Rickard, David John

(56) References cited:
- CA-A1- 2 315 931
- US-A- 4 431 717
- US-A- 5 015 546
- US-A- 5 744 930
- US-B1- 6 228 528

## Description

This invention relates to portable electronic devices, including but not limited to handheld wireless communication devices. More particularly, this invention relates to means of accommodating batteries of different sizes in such devices.

Certain portable electronic devices, handheld wireless communication devices in particular, are designed to provide various battery life options, depending on different capacity batteries being used. Batteries of different capacity tend to have different physical dimensions. These differences in dimension are typically compensated for by providing battery area access doors of varying dimension, i.e. a separate electronic devices battery door for each possible battery. It would be preferable to avoid such separate battery doors. US4431717, for example, achieves this aim. It discloses a portable electronic device having a battery compartment and a removable cover therefore, wherein said battery compartment and cover are configured to accommodate batteries of at least two different sizes. US5015546, US5744930 and CA2315931 all also disclose portable electronic devices having a battery compartment and cover that are configured to accommodate batteries of at least two different sizes.

### GENERAL

The invention therefore preferably provides various alternative and novel means for accommodating batteries of different dimensions, without requiring separate battery doors. Reference will be made to "relatively thin" batteries, and "somewhat thicker" batteries. It should be understood that "relatively thin" means relative to the thickness of the "somewhat thicker" batteries, and is not intended to indicate that the "relatively thin" battery is in fact thin compared to batteries in general.

In the invention, a portable electronic device has a battery compartment and a removable cover therefor, the portable electronic device having at least one elastomeric element secured to said cover so as to permit said battery compartment to accommodate batteries of at least two different sizes, characterized in that said at least one elastomeric element permits said battery compartment to accommodate batteries of at least two different sizes without further adaptation of the battery compartment itself.

According to one exemplary embodiment, the cover preferably has at least one elastomeric element beneath it to bear against an installed battery, the elastomeric element(s) being compressible from a position adapted to accommodate a relatively thin battery, to a position where a somewhat thicker battery can be accommodated.
Preferably, the cover has a generally rigid outer frame and a generally rigid centre portion, the outer frame and centre portion being connected by an elastomeric web portion whereby the centre portion may be displaced outwardly to accommodate a somewhat thicker battery.

Alternatively, the cover has a generally rigid outer frame and a generally rigid centre portion, said outer frame and centre portion being connected by said elastomeric element in the form of a web portion whereby said centre portion may be displaced outwardly to accommodate a somewhat thicker battery.

Preferably, the elastomeric web portion is a flexible membrane, configured to tuck into a gap between an installed battery and a side wall of the battery compartment.
In another arrangement, the cover has a generally rigid outer frame and said elastomeric element in the form of a centre portion is secured to said outer frame, whereby said centre portion may be displaced outwardly to accommodate a somewhat thicker battery. Preferably, the portable electronic device can accommodate batteries of at least two discrete sizes.

Alternatively, the at least two sizes are various sizes along a continuum of sizes.
Aspects of the invention will be described or will become apparent in the course of the following detailed description and drawings of specific embodiments of the invention, as examples only.

### BRIEF DESCRIPTION OF THE DRAWINGS

Embodiments of the invention will now be described, by way of example only, with reference to the attached drawings, in which:
Fig. 1 is a perspective view of a first exemplary embodiment in accordance with the invention;
Fig. 2 is a cross-sectional elevation view of the first embodiment, with a relatively thin battery;
Fig. 3 is a cross-sectional elevation view of the first embodiment, with a somewhat thicker battery;
Fig. 4 is a perspective view of a second exemplary embodiment in accordance with the invention, with a relatively thin battery;
Fig. 5 is another perspective view of the second embodiment, with a somewhat thicker battery;
Fig. 6 is a cross-sectional elevation view of the second embodiment, with a relatively thin battery;
Fig. 7 is a cross-sectional elevation view of the second embodiment, with a somewhat thicker battery;
Fig. 8 is a perspective view of a third exemplary embodiment in accordance with the invention, with a relatively thin battery;
Fig. 9 is another perspective view of the third embodiment, with a somewhat thicker battery;
Fig. 10 is a cross-sectional elevation view of the third embodiment, with a relatively thin battery;
Fig. 11 is a cross-sectional elevation view of the third embodiment, with a somewhat thicker battery;
Fig. 12 is a perspective view of a fourth exemplary embodiment in accordance with the invention;
Fig. 13 is a cross-sectional elevation view of the fourth embodiment, with a relatively thin battery;
Fig. 14 is a cross-sectional elevation view of the fourth embodiment, with a somewhat thicker battery;
Fig. 15 is a perspective view of an embodiment of a portable electronic device having a battery compartment for accommodating batteries of at least two different sizes, with a relatively thin battery;
Fig. 16 is another perspective view of the embodiment of Fig. 15, with a somewhat thicker battery;
Fig. 17 is a cross-sectional elevation view of the embodiment of Fig. 15, with a relatively thin battery;
Fig. 18 is a cross-sectional elevation view of the embodiment of Fig. 15, with a somewhat thicker battery;
Fig. 19 is a cross-sectional elevation view of another embodiment of a portable electronic device having a battery compartment for accommodating batteries of at least two different sizes, similar to the embodiment of Fig. 15, with a relatively thin battery;
Fig. 20 is a cross-sectional elevation view of the embodiment of Fig. 16, with a somewhat thicker battery;
Fig. 21 is a perspective view of a fifth exemplary embodiment in accordance with the invention;
Fig. 22 is a cross-sectional elevation view of a portion of the fifth embodiment;
Fig. 23 is a cross-sectional elevation view of the fifth embodiment, with a relatively thin battery;
Fig. 24 is a cross-sectional elevation view of the fifth embodiment, with a somewhat thicker battery;
Fig. 25 is a cross-sectional elevation view of an another embodiment of a portable electronic device having a battery compartment for accommodating batteries of at least two different sizes, with a relatively thin battery;
Fig. 26 is a cross-sectional elevation view of a portion of the cover of the embodiment of Fig. 25;
Fig. 27 is a cross-sectional elevation view of the embodiment of Fig. 25, with a somewhat thicker battery;
Fig. 28 is a perspective view of the battery cover of another embodiment of a portable electronic device having a battery compartment for accommodating batteries of at least two different sizes, in a position for a relatively thin battery;
Fig. 29 is a cross-sectional elevation view the cover, corresponding to Fig. 28;
Fig. 30 is a perspective view of the battery cover of the embodiment of Fig. 28, in a position for a somewhat thicker battery; and
Fig. 31 is a cross-sectional elevation view the cover, corresponding to Fig. 30.

### DESCRIPTION OF PREFERRED EMBODIMENTS

The accompanying drawings illustrate various aspects and exemplary embodiments to accommodate batteries of different sizes.

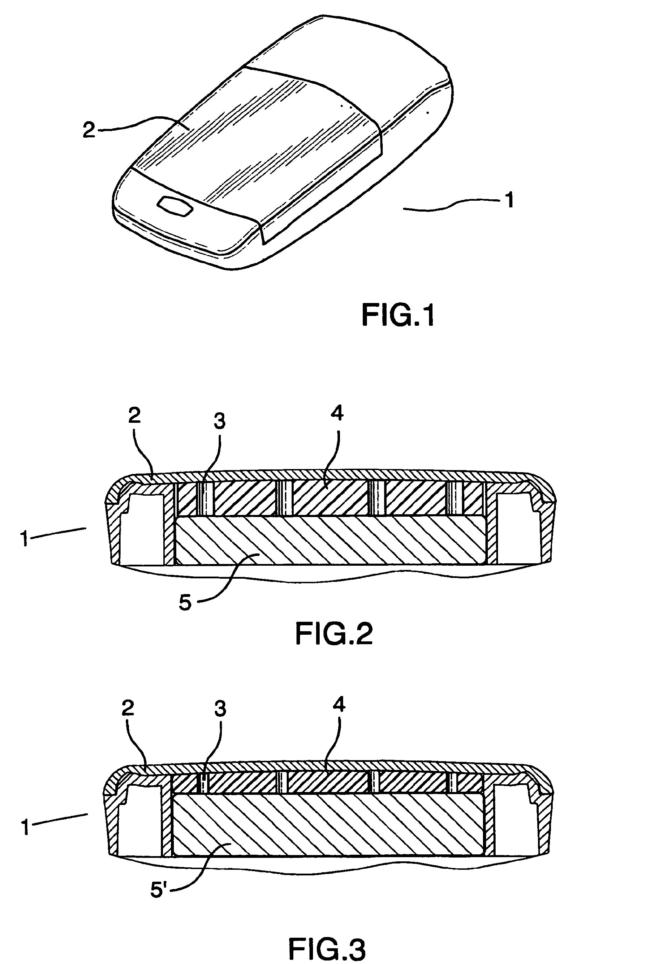

According to a first exemplary embodiment in accordance with the invention, as shown in Figs. 1-3, the handheld device 1 has a cover 2 secured to the device by any suitable conventional means, over a battery compartment 3. Inside the battery compartment, under the cover, are one or more elastomeric elements 4 which bear against an installed battery, 5 or 5'. Fig. 2 shows a relatively thin battery 5, such that the elastomeric elements are not compressed, or are compressed only sufficiently to keep the battery in position. Fig. 3 shows a somewhat thicker battery 5', such that the elastomeric elements are somewhat compressed, the compression creating more space to accommodate the larger battery.

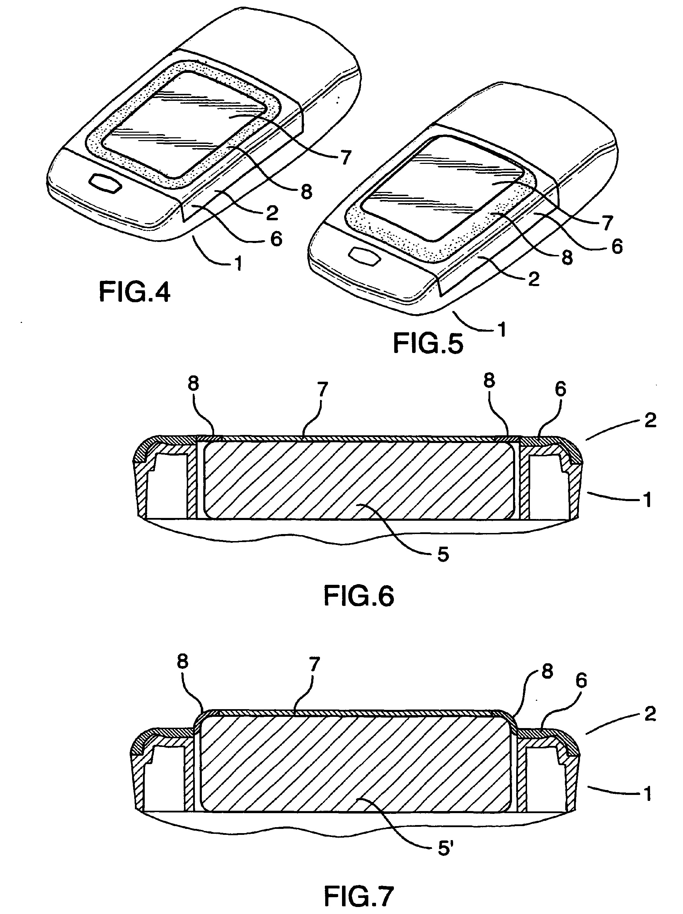

According to a second exemplary embodiment in accordance with the invention, as shown in Figs. 4-7, the handheld device 1 has a cover 2 secured to the device by any suitable conventional means, over the battery compartment 3. The cover has a generally rigid outer frame 6, for example of hard plastic or metal, and a generally rigid centre portion 7, again for example of hard plastic or metal. The outer frame and centre portion are connected by an elastomeric web portion 8, molded with or otherwise connected to both the outer frame and the centre portion. As can be seen from a comparison between Figs. 4 and 5, or especially between Figs. 6 and 7, the centre portion 7 is in one position in Figs. 4 and 6, relatively flat or generally co-planar with the outer frame 6 for example, to accommodate a relatively thin battery 5. In Figs. 5 and 7, the elastomeric web 8 is stretched, and the centre portion 7 is displaced outwardly, thereby accommodating a somewhat thicker battery 5'.

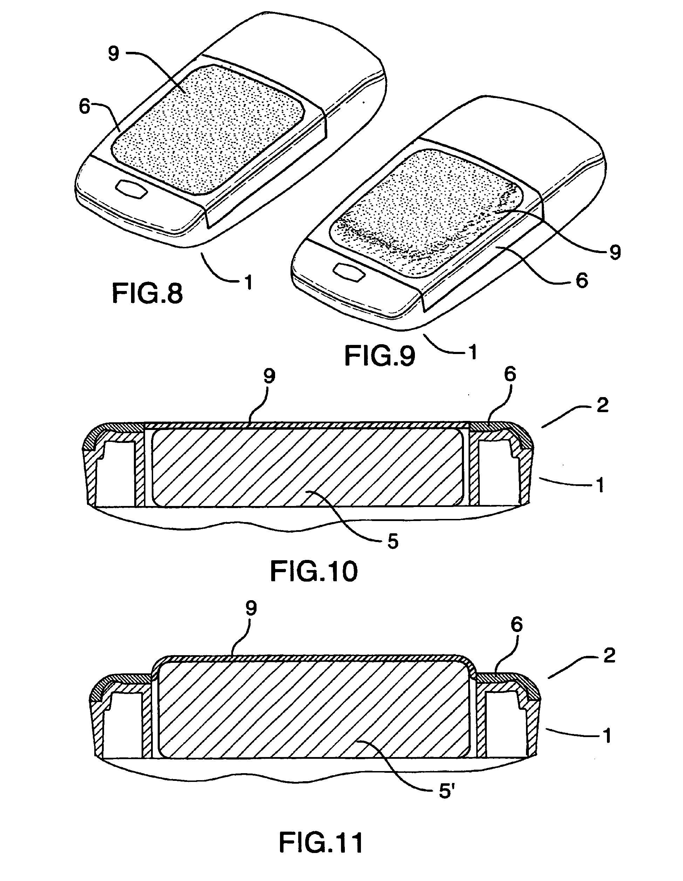

A third exemplary embodiment in accordance with the invention, similar to the second embodiment, is shown in Figs. 8-11. In this embodiment, there is no generally rigid centre portion. Instead, there is an elastomeric portion 9 secured to the outer frame 6, spanning across the battery compartment. As can be seen from a comparison between Figs. 8 and 9, or especially between Figs. 10 and 11, the elastomeric portion 9 is in one position in Figs. 8 and 10, relatively flat or generally co-planar with the outer frame 6 for example, to accommodate a relatively thin battery 5. In Figs. 9 and 11, the elastomeric portion 9 is stretched, particularly towards outer edges thereof, thereby accommodating a somewhat thicker battery 5'.

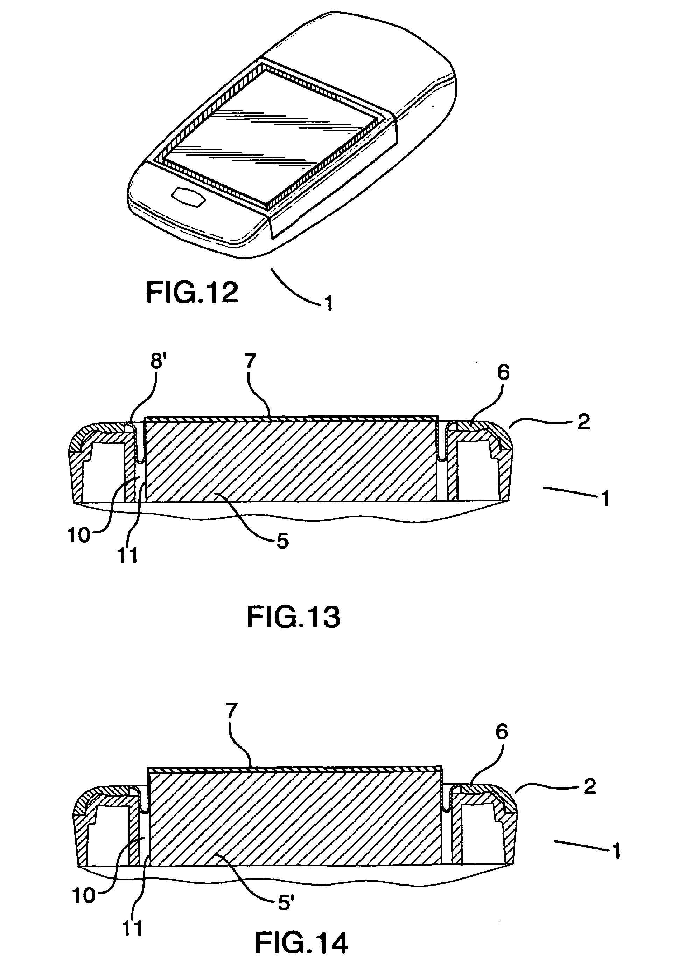

A fourth exemplary embodiment in accordance with the invention, also similar to the second embodiment, is shown in Figs. 12-14. In this embodiment, the cover again has a generally rigid outer frame 6 and a generally rigid centre portion 7, and the outer frame and centre portion are again connected by an elastomeric web portion. However, the elastomeric web portion 8', is in the form of a flexible membrane, molded with or otherwise connected to both the outer frame and the centre portion. The membrane tucks into a small gap 10 between the battery 5 or 5' and the side wall 11 of the battery compartment. As with the previous embodiments, Figs. 13 and 14 show the comparison between accommodating a relatively thin battery 5 and a somewhat thicker battery 5'.

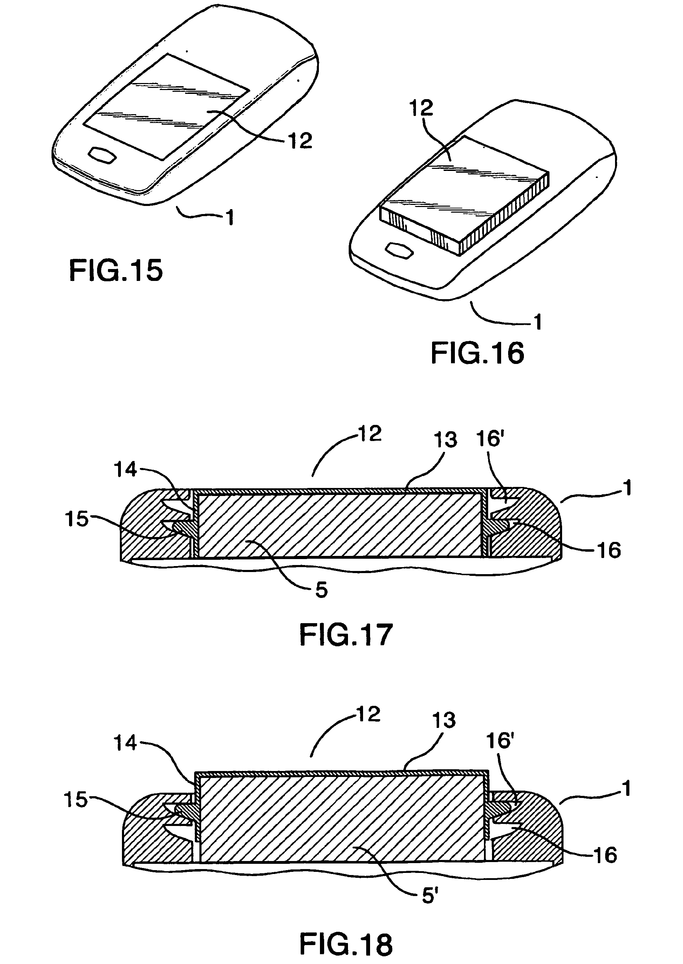

Figs. 15-18 illustrate an embodiment of a portable electronic device having a battery compartment for accommodating batteries of at least two different sizes. In this embodiment, a battery cover 12 has an outer surface 13 and side walls 14 encompassing the battery 5 or 5'. The battery cover preferably is generally rigid, but could be somewhat flexible. Extending outwardly from the side walls 14 are flexible engagement means 15 such as elastomeric or otherwise flexible tabs or a flange, which can engage corresponding recesses 16 or 16' at two or more relative heights. The battery cover is installed by pressing it downwardly into the battery compartment, such that the flexible engagement means snap or pop into the relevant recess or recesses. One recess height, shown in Fig. 17, corresponds to a relatively thin battery 5, while the other recess height, shown in Fig. 18, corresponds to a somewhat thicker battery 5'. There could be additional recess heights if desired. The flexible engagement means 15 could be tabs placed at several locations around the circumference of the battery cover, with recesses at corresponding locations, or could be in the form of a continuous flange extending all the way around the battery cover. The tabs or flange could be integral to the battery cover, or could be a separate piece. Although elastomeric tabs or an elastomeric flange are primarily contemplated, it should be appreciated that analogous means could be employed instead. For example, the battery cover could be provided with a ball-spring arrangement, to engage detents at different heights in the battery compartment, or the reverse could be provided, i.e. ball-spring arrangements in the battery compartment, engaging detents in the side walls of the battery cover.

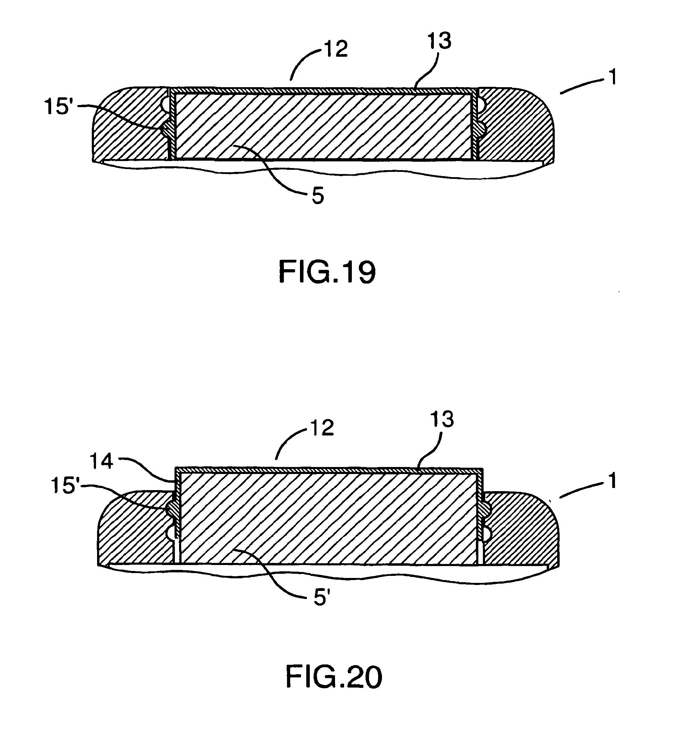

Figs. 19 and 20 show another embodiment of a portable electronic device having a battery compartment for accommodating batteries of at least two different sizes, very similar to the preceding embodiment, in which the flexible engagement means 15 is in the form of elastomeric dimples engaging corresponding recesses. The ball-spring arrangement referred to above would be somewhat similar in concept and appearance.

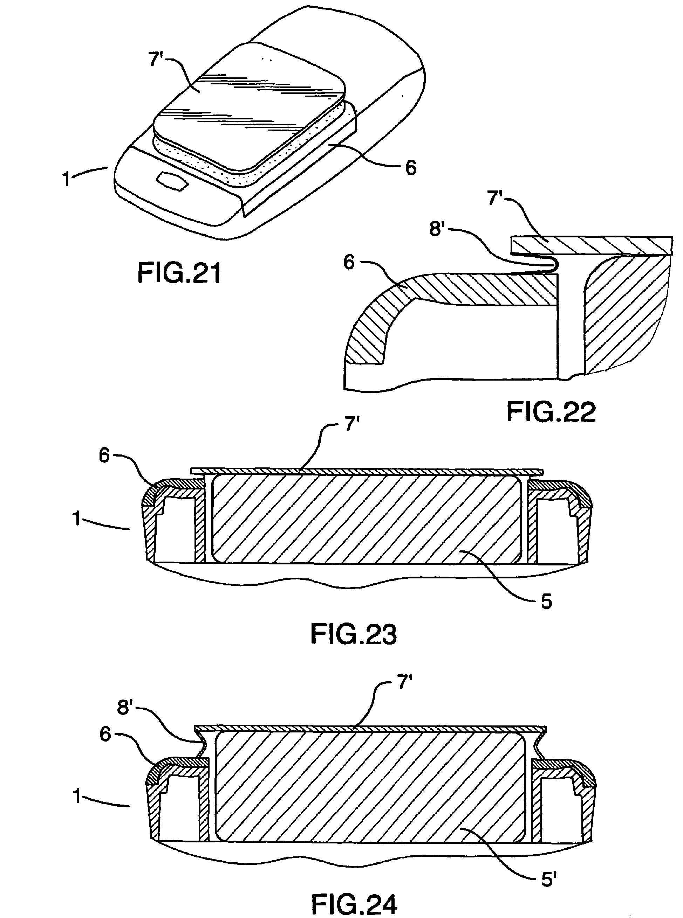

Figs. 21-24 show a fifth exemplary embodiment in accordance with the invention, similar in concept to the second and fourth embodiments in particular. In this embodiment, the cover has a generally rigid outer frame 6, for example of hard plastic or metal, and a generally rigid centre portion 7', again for example of hard plastic or metal. The outer frame and centre portion are connected by a web portion 8', molded with or otherwise connected to both the outer frame and the centre portion. This web portion 8' is of a springy material, biased to the position shown in Fig. 23. To accommodate a somewhat thicker battery 5', the web portion 8' expands outwardly as shown in Fig. 24.

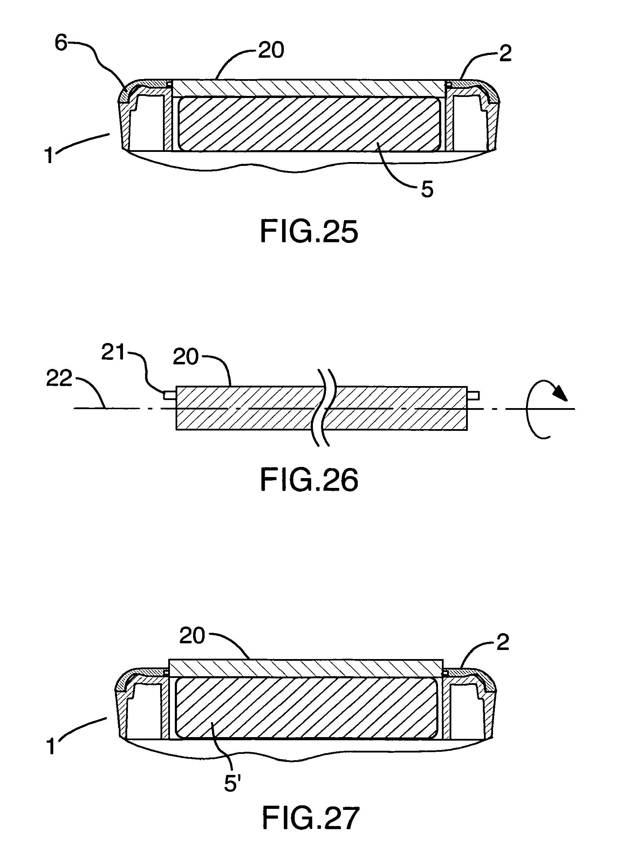

Figs. 25-27 show another embodiment of a portable electronic device having a battery compartment for accommodating batteries of at least two different sizes, in which the battery cover 20 itself, or a portion thereof, is reversible and has tabs or flanges 21 displaced from the centreline 22. As can be seen from comparing Figs. 25 and 27, flipping the cover or cover portion thus creates a smaller or larger space for the battery 5 or 5'.

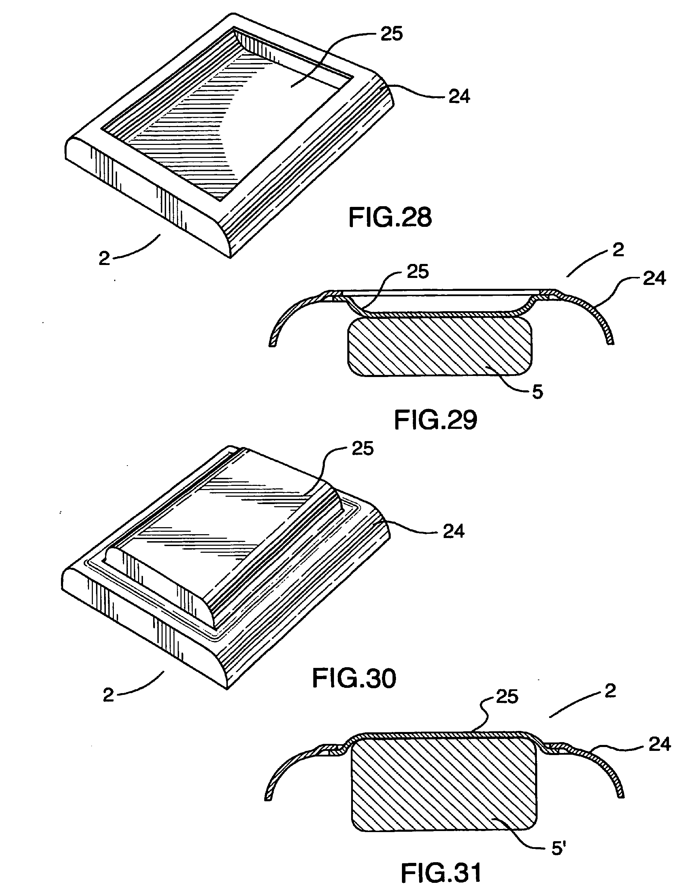

Figs. 28-31 show another embodiment of a portable electronic device having a battery compartment for accommodating batteries of at least two different sizes, in which the battery cover 2 is in two pieces, namely an outer frame 24, and a central portion 25. As can be readily seen from the drawings, the centre portion can be installed in one of two positions, according to a principle somewhat similar to the preceding embodiment. Depending on which orientation is used, a smaller or larger space for the battery 5 or 5' is created.

The preceding exemplary embodiments in accordance with the invention illustrate various aspects of the invention, but as examples only. It will be appreciated that many additional variations and examples are possible, and will be apparent to those knowledgeable in the field of the invention. Thus the scope of the invention, as defined in the following claims, is not limited to these specific examples.

Without limiting the generality of the foregoing, further aspects may include, for example, any other obvious variations as to how the battery cover may be configured or installed to provide varying battery compartment sizes; any obvious variations in choices of materials, degree of flexibility or resilience, if any, and any obvious variations in size, shape or other characteristics not relevant to the point of the invention. It should also be noted that although certain of the exemplary embodiments above lend them selves to discrete battery sizes only, others (for example embodiments with elastomeric elements) may lend themselves to a variety of battery sizes, along a continuum.

## Claims

1. A portable electronic device (1) having a battery compartment (3) and a removable cover (2) therefor, the portable electronic device having at least one elastomeric element (4, 8, 8', 9) secured to said cover (2) so as to permit said battery compartment to accommodate batteries (5, 5') of at least two different sizes, **characterized in that** said at least one elastomeric element (4, 8, 8', 9) permits said battery compartment to accommodate batteries (5, 5') of at least two different sizes without further adaptation of the battery compartment itself.

2. The portable electronic device of claim 1, wherein said cover (2) has at least one said elastomeric element (4) beneath said cover to bear against an installed battery, said elastomeric element(s) being compressible from a position adapted to accommodate a relatively thin battery, to a position where a somewhat thicker battery can be accommodated.

3. The portable electronic device of claim 1, wherein said cover (2) has a generally rigid outer frame (6) and a generally rigid centre portion (7), said outer frame and centre portion being connected by said elastomeric element in the form of a web portion (8) whereby said centre portion may be displaced outwardly to accommodate a somewhat thicker battery.

4. The portable electronic device of claim 3, wherein said elastomeric web portion is a flexible membrane (8'), configured to tuck into a gap (10) between an installed battery and a side wall (11) of the battery compartment.

5. The portable electronic device of claim 1, wherein said cover (2) has a generally rigid outer frame (6) and said elastomeric element in the form of a centre portion (9) secured to said outer frame, whereby said centre portion may be displaced outwardly to accommodate a somewhat thicker battery.

6. The portable electronic device of any one of claims 1 to 5, wherein said at least two sizes are discrete sizes.

7. The portable electronic device of any one of claims 1 to 5, wherein said at least two sizes are various sizes along a continuum of sizes.

## Patentansprüche

1. Ein tragbares elektronisches Gerät (1) mit einem Batteriefach (3) und einer abnehmbaren Abdeckung (2) für dieses, wobei das tragbare elektronische Gerät mindestens ein an der Abdeckung (2) befestigtes elastomeres Element (4, 8, 8', 9) aufweist, um zu ermöglichen, dass das Batteriefach (3) Batterien (5, 5') von mindestens zwei unterschiedlichen Größen aufnehmen kann, **dadurch gekennzeichnet, dass** das mindestens eine elastomere Element (4, 8, 8', 9) es dem Batteriefach ermöglicht, Batterien (5, 5') von mindestens zwei unterschiedlichen Größen aufzunehmen, ohne dass dazu am Batteriefach selbst Veränderungen vorgenommen werden müssen.

2. Das tragbare elektronische Gerät gemäß Anspruch 1, wobei die Abdeckung (2) mindestens ein elastomeres Element (4) unter der Abdeckung aufweist, um gegen eine installierte Batterie zu drücken, wobei das elastomere Element bzw. die elastomeren Elemente komprimierbar ist bzw. sind aus einer Position, die zur Aufnahme einer relativ dünnen Batterie angepasst ist, in eine Position, in der eine etwas dickere Batterie aufgenommen werden kann.

3. Das tragbare elektronische Gerät gemäß Anspruch 1, wobei die Abdeckung (2) einen im Wesentlichen steifen äußeren Rahmen (6) und einen im Wesentlichen steifen zentralen Abschnitt (7) aufweist, wobei der äußere Rahmen und der zentrale Abschnitt durch das elastomere Element in Form eines Gewebeabschnitts (8) miteinander verbunden sind, wodurch der zentrale Abschnitt nach außen verschoben werden kann, um eine etwas dickere Batterie aufzunehmen.

4. Das tragbare elektronische Gerät gemäß Anspruch 3, wobei der elastomere Gewebeabschnitt eine flexible Membran (8') ist, die so konfiguriert ist, dass sie in einem Zwischenraum (10) zwischen einer installierten Batterie und einer Seitenwand (11) des Batteriefachs verstaut wird.

5. Das tragbare elektronische Gerät gemäß Anspruch 1, wobei die Abdeckung (2) einen im Wesentlichen steifen äußeren Rahmen (6) und das elastomere Element in Form eines zentralen Abschnitts (9) aufweist, der am äußeren Rahmen befestigt ist, wodurch der zentrale Abschnitt nach außen verschoben werden kann, um eine etwas dickere Batterie aufzunehmen.

6. Das tragbare elektronische Gerät gemäß jedem der Ansprüche 1 bis 5, wobei die mindestens zwei Größen diskrete Größen sind.

7. Das tragbare elektronische Gerät gemäß jedem der Ansprüche 1 bis 5, wobei die mindestens zwei Größen verschiedene Größen aus einem Kontinuum von Größen sind.

## Revendications

1. Dispositif électronique portable (1) ayant un compartiment de piles (3) et un couvercle amovible (2) pour celui-ci, le dispositif électronique portable ayant au moins un élément élastomère (4, 8, 8', 9) fixé audit couvercle (2) de façon à permettre audit compartiment de piles de loger des piles (5, 5') d' au moins deux tailles différentes, se caractérisant en cela que ledit au moins un élément élastomère (4, 8, 8', 9) permet audit compartiment de piles de loger des piles (5, 5') d'au moins deux tailles différentes sans adaptation complémentaire du compartiment de piles lui-même.

2. Dispositif électronique portable de la revendication 1, dans lequel ledit couvercle (2) a au moins un élément élastomère (4) sous ledit couvercle pour appuyer contre une pile installée, le(s)dit(s) élément(s) élastomère(s) étant compressible(s) d'une position adaptée pour loger une pile relativement mince à une position où une pile légèrement plus épaisse peut être logée.

3. Dispositif électronique portable de la revendication 1, dans lequel ledit couvercle (2) a un cadre extérieur généralement rigide (6) et une partie centrale généralement rigide (7), lesdits cadre externe et partie de centre étant connectés par ledit élément élastomère en forme de partie en toile (8) ladite partie centrale pouvant être déplacée vers l'extérieur pour loger une pile légèrement plus épaisse.

4. Dispositif électronique portable de la revendication 3, dans lequel ladite partie en toile élastomère est une membrane souple (8') configurée pour se loger dans un espace (10) entre une pile installée et une paroi latérale (11) du compartiment de piles.

5. Dispositif électronique portable de la revendication 1, dans lequel ledit couvercle (2) a un cadre externe généralement rigide (6) et ledit élément élastomère en forme de partie centrale (9) fixé audit cadre externe, ladite partie centrale pouvant être déplacée vers l'extérieur pour loger une pile légèrement plus épaisse.

6. Dispositif électronique portable de l'une quelconque des revendications 1 à 5, dans lequel lesdites au moins deux tailles sont des tailles discrètes.

7. Dispositif électronique portable de l'une quelconque des revendications 1 à 5, dans lequel les au moins deux tailles sont différentes tailles parmi une continuité de tailles.
